Europäisches Patentamt

(19) European Patent Office

Office européen des brevets

(11) Publication number : **0 476 801 A2**

(12) **EUROPEAN PATENT APPLICATION**

(21) Application number : **91302340.4**

(22) Date of filing : **19.03.91**

(51) Int. Cl.$^5$ : **H01L 21/3105, H01L 21/033, H01L 21/28, H01L 21/266, H01L 21/335**

(30) Priority : **20.09.90 JP 252709/90**

(43) Date of publication of application :
**25.03.92 Bulletin 92/13**

(84) Designated Contracting States :
**DE FR GB**

(71) Applicant : **MITSUBISHI DENKI KABUSHIKI KAISHA**
**2-3, Marunouchi 2-chome Chiyoda-ku Tokyo (JP)**

(72) Inventor : **Oku, Tomoki, c/o Mitsubishi Denki K. K.**
**Optelectronie and Microwave Devices R & D Lab.**
**1, Mizuhara 4-chome, Itami-shi, Hyogo-ke (JP)**

(74) Representative : **Beresford, Keith Denis Lewis et al**
**BERESFORD & Co. 2-5 Warwick Court High Holborn**
**London WC1R 5DJ (GB)**

(54) Production of a semiconductor device using implantation into a thermohardening resin.

(57) A particle beam implantation into a thermohardening resin has an effect in hardening the thermohardening resin of the implanted region sufficiently, and the non-implanted part is not hardened. Therefore, the non-hardened resin of the non-implanted part can be removed at high selectivity with the hardened resin of the implanted part and an inverted pattern comprising hardened resin is produced.

(b)

ion implantation

## FIELD OF THE INVENTION

The present invention relates to a production method of a semiconductor device, and more particularly to a method of producing a fine mask pattern in the production of a compound semiconductor device.

## BACKGROUND OF THE INVENTION

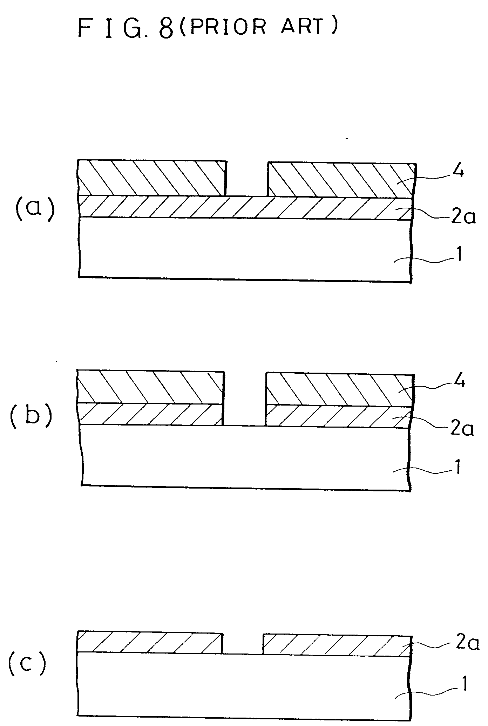

Figure 8 shows a method of producing an aperture of a gate part in HEMT (High Electron Mobility Transistor) recited in Electronics Letters vol.24 (1988) pp.1327 by I. Hanyu et al. In figure 8, reference numeral 1 designates a compound semiconductor substrate. A $SiO_2$ film 2a is produced on the substrate 1. A photoresist 4 is produced on the $SiO_2$ film 2a.

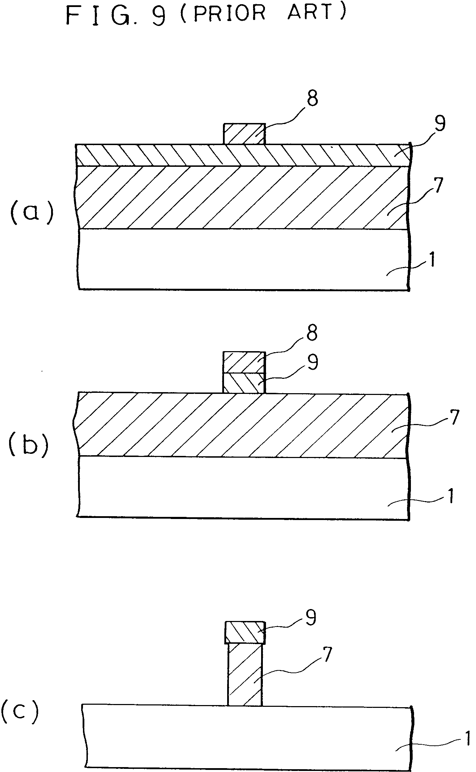

Figure 9 shows a triple-layer photoresist production method used for producing a dummy pattern of a gate part in SAINT (Self-Aligned Implantation for $N^+$-layer Technology) MESFET (Metal Semiconductor Field Effect Transistor) recited in IEEE Transactions, vol.ED-29, (1982) pp.1772 by K. Yamasaki et al. In figure 9, reference numeral 1 designates a compound semiconductor substrate. A lower layer photoresist 7 is produced on the substrate 1. An upper layer photoresist 8 comprising material having a higher resolution than that of the lower layer photoresist 7 is disposed on the lower layer photoresist 7. Reference numeral 9 designates a sputtered $SiO_2$ film.

A description is given of a production method of an aperture shown in figure 8.

First of all, as shown in figure 8(a), a $SiO_2$ film 2a is plated on the compound semiconductor substrate 1 by plasma CVD or sputtering. Next, photoresist 4 is plated and a photoresist pattern is produced therefrom. An optical exposure or an EB (electron beam) exposure is used for the patterning of photoresist 4 and an appropriate photoresist is used for the photoresist 4 depending on the exposure method used. EB exposure is used in the case of I. Hanyu et al.. Thereafter, as shown in figure 8(b) the $SiO_2$ film 2a is etched by RIE (Reactive Ion Etching) using the photoresist 4 as a mask, and as shown in figure 8(c) the photoresist 4 is removed to produce the $SiO_2$ film 2a having an aperture on the compound semiconductor substrate 1. In the case of 1. Hanyu et al., thereafter sputtering metal is sputtered on the entire surface of substrate and a gate having a Schottky barrier comprising metal and semiconductor is produced at the aperture, and thus a HEMT is produced.

A description is given of a production method of a triple-layer photoresist shown in figure 9.

As shown in figure 9(a), a lower layer photoresist 7 is plated on the compound semiconductor substrate 1 and an $SiO_2$ film 9 is plated thereon by sputtering and further an upper layer photoresist 8 having a higher resolution than that of the lower layer photoresist 7 is plated. Next, as shown in figure 9(b), the sput-

tered $SiO_2$ film 9 is etched by RIE using such as $CF_4$ + $O_2$ gas, using the upper layer photoresist 8 as a mask. Finally, as shown in figure 9(c), reactive ion etching is carried out using such as $O_2$ gas using the sputtered $SiO_2$ film 9 as a mask, and a pattern of the lower layer photoresist 7 is produced. Meanwhile the upper layer photoresist 8 is removed by the RIE using $O_2$ gas.

This technique has the characteristic that the pattern of upper photoresist 8 having low anti-RIE property but high resolution can be transferred onto the lower layer photoresist 7 having high thermal stability, high anti-RIE property, and large film thickness. Therefore, the thermal stability and anti-RIE property of the lower layer photoresist 7 can be utilized in the later process. Furthermore, a process utilizing advantages that it has a large film thickness and a high resolution can be carried out.

The prior art production method of a semiconductor device constituted as described above has the following problems.

First of all, in the method of producing an aperture shown in figure 8, when the $SiO_2$ film 2a is etched by RIE, the photoresist 4 is also etched, thereby increasing the size of the aperture. When the aperture is used as a gate of an FET, it means that the gate length is increased and for example even when the photoresist 4 is produced in an aperture size of 0.2 micron by electron beam exposure, the aperture size of the $SiO_2$ film 2a after RIE increases to about 0.3 micron. This reduces transconductance gm or the like of the transistor.

Furthermore, in the method shown in figure 8, a damage by RIE enters into the exposed part of the surface of the semiconductor substrate 1 when the $SiO_2$ film 2a is etched by RIE. The damages below the gate of the transistor cause a lowering of the controllability of transconductance gm and the threshold voltage $V_T$.

Next, in the triple-layer photoresist production method shown in figure 9, when sputtered $SiO_2$ film 9 is etched by RIE using the upper layer photoresist 8 as a mask, the photoresist 8 is also etched and the pattern of sputtered $SiO_2$ film 9 becomes smaller than that of the upper layer photoresist 8. Furthermore, when the lower layer photoresist 7 is etched by RIE using $O_2$ gas using the sputtered $SiO_2$ film 9 as a mask, the pattern of the photoresist 7 becomes further smaller than that of sputtered $SiO_2$ film 9. Therefore, the use of this method for producing a short gate requires RIE conditions having quite high selectivity, thereby resulting in difficulty to a great extent. Actually the gate length of SAINT MESFET is about 0.3 micron and it is difficult to further reduce the size at present.

## SUMMARY OF THE INVENTION

The present invention is directed to solving the above described problems and has for its object to provide a production method of a semiconductor device that can transfer a pattern which is obtained by optical exposure or electron beam exposure onto a metal, insulating film, or photoresist on a substrate in fine pattern and at high controllability.

It is another object of the present invention to provide a production method of a semiconductor device that can produce an ion implantation region self-aligned with the pattern in the production process of such pattern.

It is still another object of the present invention to provide a production method of a semiconductor device that can select arbitrarily the kind of ions and the amount of implantation of the self-alignedly produced ion implantation region.

It is still another object of the present invention to provide a method of producing a MESFET, a MESFET having a low resistance gate electrode, or a HEMT as an application of the above described production method.

Other objects and advantages of the present invention will become apparent from the detailed description given hereinafter; it should be understood, however, that the detailed description and specific embodiment are given by way of illustration only, since various changes and modifications within the spirit and scope of the invention will become apparent to those skilled in the art from this detailed description.

In accordance with a first aspect of the present invention, thermohardening resin is provided on a ground substrate, particle beam is implanted selectively into this thermohardening resin, the resin of the particle beam implantation region is hardened, an inverted pattern is produced by removing the non-hardened part to which particle beam is not implanted, and the pattern is utilized as a mask pattern for the later processing.

In accordance with a second aspect of the present invention, the particle beam implantation process includes a process of implanting the kind of ions that are to be donors, acceptors or deep levels in the semiconductor of the ground substrate including semiconductor layer at an implantation energy of which ions can reach in the semiconductor layer.

In accordance with a third aspect of the present invention, thermohardening resin is plated on the semiconductor substrate or on the substrate on which an insulating film is plated, a photoresist pattern is provided on the thermohardening resin, ions which are to be donors, acceptors, or deep levels in the semiconductor are implanted at an energy of which ions can reach the semiconductor substrate, the thermohardening resin of the implantation region is sufficiently hardened to produce an ion implantation region in the semiconductor-substrate, the photoresist pattern and the non-hardened thermohardening resin are removed, a pattern is transferred onto the lower layer semiconductor substrate or the insulating film on the semiconductor substrate using the remaining thermohardening resin as a mask, and an aperture is produced self-aligned with the ion implantation region.

In accordance with a fourth aspect of the present invention, thermohardening resin is plated on a semiconductor substrate or a semiconductor substrate on which an insulating film is plated, a photoresist pattern is provided on the thermohardening resin, particle beam implantation is carried out using this as a mask, thermohardening resin of the particle beam implantation region is sufficiently hardened, ions which are to be donors, acceptors, or deep levels in the semiconductor are implanted at an energy of which ions can reach in the semiconductor substrate thereby to produce an ion implantation region in the semiconductor substrate, the photoresist pattern and the non-hardened thermohardening resin are removed, a pattern is transferred onto the lower layer semiconductor substrate and the insulating film on the semiconductor substrate using the remaining thermohardening resin as a mask, and an aperture is produced self-aligned with the ion implantation region.

In accordance with a fifth aspect of the present invention, in the above-described production method, an active region is previously produced in a semiconductor substrate, the ion implantation regions to which ions which are to be donors or acceptors in the semiconductor are implanted serving as a source and a drain region are produced in the substrate, a Schottky metal is provided at an aperture which is produced self-aligned with the ion implantation region by the pattern transfer, the thermohardening resin on the source and drain region are removed, and an ohmic electrode is produced on the portion where the thermohardening resin is removed, thereby producing a MESFET.

In accordance with a sixth aspect of the present invention, in a production method of a semiconductor device, thermohardening resin is plated on a compound semiconductor substrate on which an active region is produced directly or via an insulating film, the regions corresponding to the gate electrode, drain electrode, and source electrode production region on the thermohardening resin are covered by photoresist, a particle beam is implanted into the thermohardening resin using the photoresist pattern as a mask, the thermohardening resin of the particle beam implantation region is sufficiently hardened, the non-hardened thermohardening resin at a photoresist pattern and gate electrode production region are removed, the compound semiconductor substrate or the insulating film on the substrate exposed thereby are etched, a recess groove reaching the active layer is produced, a Schottky metal is plated on the groove part, non-hardened thermohardening resin at the source and drain electrode production region is removed, thereby to expose the compound semiconductor substrate, and an ohmic electrode is plated on the exposed part, thereby producing a HEMT.

In accordance with the first aspect of the present invention, the particle beam implantation into the thermohardening resin has an effect of hardening sufficiently the thermohardening resin of the implanted region, but in contrast, the non-implanted part is not hardened. Therefore, non-hardened resin of the non-implanted part can be removed at high selectivity with the hardened resin of the injected part and an inverted pattern comprising hardened resin is produced.

When kinds of ion which are to be donors, acceptors, or deep levels in the semiconductor are used for the injected particle beam and they are implanted at an implantation energy of which ions can reach the semiconductor substrate, hardening resin is produced by ion implantation as well as an ion implantation region is produced self-aligned with an inverted pattern comprising hardening resin in the substrate.

Furthermore, when this inverted pattern is transferred onto the ground substrate, an aperture pattern can be produced self-aligned with the ion implantation region in the substrate and the inverted pattern comprising hardened resin is constituted of the particle beam implantation region and the thermal diffused region from the particle beam implantation region, whereby the aperture pattern becomes smaller than the pattern of initial stage used for implanting particle beam into the thermohardening resin, thereby preventing broadening of a pattern at the production of the aperture pattern. Furthermore, by providing a Schottky metal at this aperture part and providing an ohmic electrode on the ion implantation region, a MESFET can be easily produced.

In a particle beam implantation process which is divided into two, at one of which an initial stage particle beam implantation is carried out at an energy of which ions cannot reach the semiconductor substrate and at the other of which ions which are to be donors, acceptors, or deep levels in the semiconductor at an implantation energy of which ions can reach the semiconductor substrate before removing the photoresist, an aperture pattern which has no broadening against the initial pattern can be produced self-aligned with the implantation region by pattern transferring printing and also the particle beam implantation for hardening the thermohardening resin and ion implantation for producing an ion implantation region can be carried out independently, whereby the kind of ions and the amount of the implantation to be implanted into the active region can be arbitrarily selected.

In addition, if an aperture pattern is provided using an inverted pattern which is produced by implanting particle beam selectively to the thermohardening resin and a Schottky metal is plated to the aperture pattern and an ohmic metal is plated on the other aperture pattern, a fine pattern gate which is determined self-aligned with the ohmic electrode is produced and the distance between the ohmic metal and the Schottky metal is determined by the initial stage photoresinst pattern.

## BRIEF DESCRIPTION OF THE DRAWINGS

Figure 1 is a cross-sectional side view showing a production method of a semiconductor device in accordance with a first embodiment of the present invention;

Figure 2 is a cross-sectional side view showing a production method of a semiconductor device in accordance with a second embodiment of the present invention;

Figure 3 is a cross-sectional side view showing a production method of a semiconductor device in accordance with a third embodiment of the present invention;

Figure 4 is a cross-sectional side view showing a production method of a semiconductor device in accordance with a fourth embodiment of the present invention;

Figure 5 is a cross-sectional side view showing a production method of a semiconductor device in accordance with a fifth and a sixth embodiments of the present invention;

Figure 6 is a cross-sectional side view showing a production method of a semiconductor device in accordance with a seventh embodiment of the present invention;

Figure 7 is a diagram showing a range of ions in a $SiO_2$ film;

Figure 8 is a cross-sectional side view showing a production method of a semiconductor device according to the prior art production method of an aperture; and

Figure 9 is a cross-sectional side view showing a production method of a semiconductor device according to another prior art production method of an aperture.

## DETAILED DESCRIPTION OF THE PREFERRED EMBODIMENTS

An embodiment of the present invention will be described in detail with reference to the drawings.

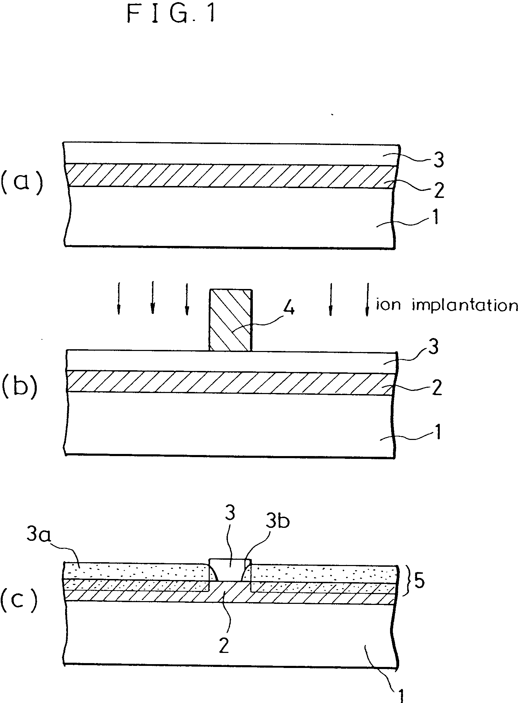

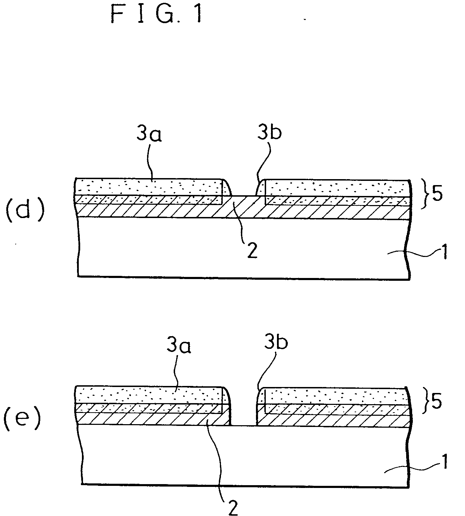

Figure 1 is a cross-sectional view showing main process steps of a production method of a semiconductor device in accordance with a first embodiment of the present invention. In figure 1(a), reference numeral 1 designates a compound semiconductor substrate. A SiN film 2 is produced on the substrate 1 by plasma CVD. Thermohardening resin film 3 is produced on the SiN film 2. This thermohardening resin 3 is sintered to be hardened at 100°C.

Here, as an example of the thermohardening resin 3, resin used for spin on glass (SOG) will be described. SOG resin is obtained by dissolving silicon compound of $Si-O-CH_3$ shaped configuration into ethanol series solvent and when it is plated on a wafer, it becomes a thin film of approximately 1000 to 5000 angstroms. When this is heated, $CH_3$ and $H_2O$ are evaporated and an $SiO_2$ thin film is produced on the wafer. When it is heated up to about 1000°C, the $SiO_2$ thin film has approximately the same film quality as that of a thermal $SiO_2$ film and the etching rate against hydrofluoric acid also becomes the same as that of a thermal $SiO_2$ film (etching rate of 30 angstroms/min is obtained by hydrofluoric acid which is diluted to 200 times by water). Accordingly, it is insufficient only to heat the same at 100 °C as shown in the above-described embodiment, and the etching rate against hydrofluoric acid is quite large to be such as an etching rate of 700 angstroms/min when hydrofluoric acid which is diluted to about 200 times by water is used.

Next, as shown in figure 1(b), a photoresist pattern 4 is produced on the thermohardening resin 3 which is hardened. As for the photoresist 4, electron beam photoresist which is subjected to an electron beam exposure can be used. However, here photoresist which is obtained by applying optical exposure to a pattern of 0.4 micron is used. Then, a particle beam is implanted using the photoresist pattern 4 as a mask. For the particle beam, electron beam, ion beam, or neutral particle beam can be used, but here ion implantation is adopted because ion implantation has a large obstruction ability as an advantage in hardening resin and can be easily obtained by an implantation apparatus. Here, because ions reach up to the $SiN_2$ film 2, those ions that do not become impurities in the film such as silicon or nitrogen diluted gas ion are desirably used. When ions which become impurity are selected, they should be removed after metal is plated on the aperture.

The implantation energy of the ion is selected such that the range thereof is larger than the film thickness of the thermohardening resin and is smaller than the thickness up to the semiconductor substrate.

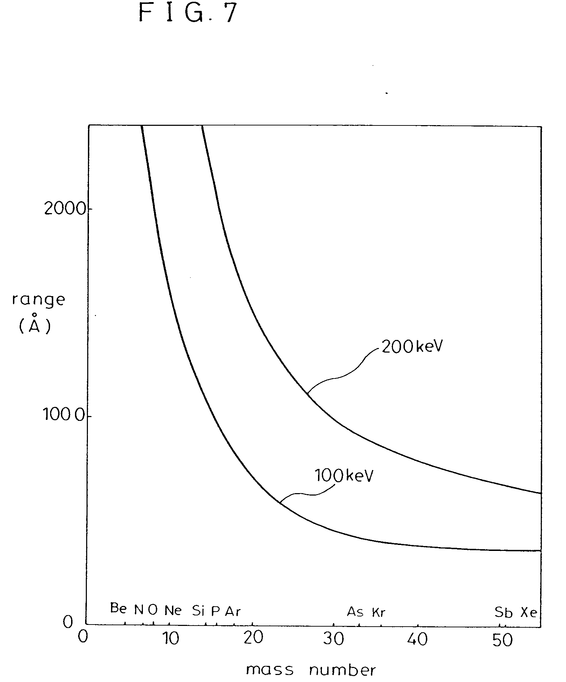

The ranges of ions in the $SiO_2$ film are shown in figure 7. This shows it is sufficient that silicon ion or argon ion is injected at 100 KeV and krypton ion is injected at 200 Kev when the thickness of thermohardening resin is 700 angstroms and that of SiN film is 1000 angstroms. The amount of implantation is enough to be $1 \times 10^{15} cm^{-2}$ when silicon ion is used, which is obvious from the measurement result of sintering. In a case of argon ion or krypton ion, the range is short, therefore the resin is hardened at small amount of implantation.

Here, the film thickness of the thermohardening resin which is hardened by the ion implantation is thinner than the one before hardened.

Next as shown in figure 1(c), reference numeral 5 designates a first ion implantation region. The first ion implantation region 5 is a region where ions which are not required to be donors, acceptors, or deep levels in the compound semiconductor are implanted. In figure 1(c), the photoresist 4 is removed. Furthermore, reference numeral 3b designates a region to which ions are not implanted but is hardened by thermal diffusion of ions from the implantation region 3a. Therefore, the size of the region 3b can be controlled by the implantation conditions such as energy, the kind of ions, and implantation rate.

Figure 1(d) shows a state after it is processed for 1 minute and 30 seconds by hydrofluoric acid which is diluted to 200 times by water. The portion where the resin is hardened is only removed by 50 angstroms or less (etching rate : 30 angstroms/min). Therefore, even if it is removed by hydrofluoric acid, the hardened portion is hardly etched.

Finally, as shown in figure 1(e), the SiN film 2 is plasma etched using the hardened resin as a mask. The etching rate of SiN to $SiO_2$ is about 15 times when $SF_6$ is used as an etching gas.

In the above described processes, because all the etching processes have selectivity of 10 or more and method such as hardening of resin by ion implantation having high controllability is used, there are no unstable factors in this production method.

Furthermore, the fact that the thermohardening resin is hardened by thermal diffusion of ions from the implantation region means that the pattern which is finally produced becomes smaller than the initial pattern. This means that the problem that the pattern is broadened at the time of producing an aperture pattern in the prior art method can be solved.

A description is given of a second embodiment of the present invention utilizing the above described first embodiment.

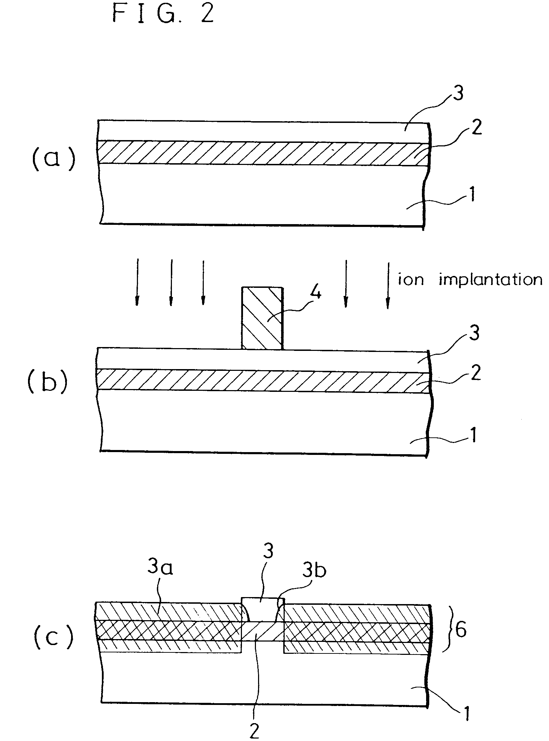

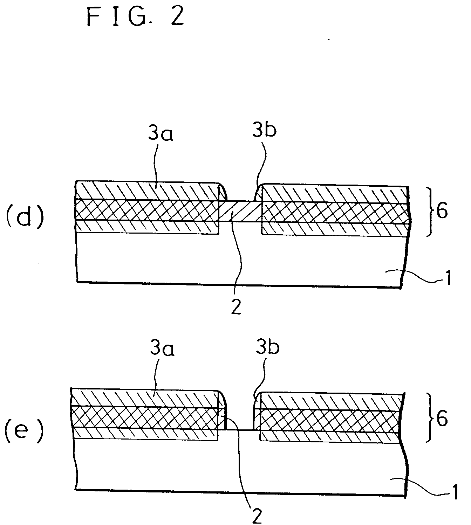

Figure 2(a) is the same as the figure 1(a). In figure 2(b), the photoresist 4 is produced and the ion implantation is carried out. As for ion which is used at this time, ions which are to be donors, acceptors, or deep levels in the compound semiconductor are selected so that ion implantation into the compound semiconductor are conducted simultaneously with hardening of the thermohardening resin. Generally, silicon ion is implanted in order to produce donor, beryllium ion or magnesium ion is implanted in order to produce acceptor, and boron ion or hydrogen ion is implanted in order to produce deep level. The energies of respective ions can be selected from figure 7, for example, silicon may be implanted at an energy of 200 KeV and a dose amount of $1 \times 10^{15} cm^{-2}$. Here, the thickness of thermohardening resin is 700 angstroms and the thickness of SiN film is 1000 angstroms.

Figures 2(c) to (e) show the same production flow as those of figures 1(c) to (e). Reference numeral 6 designates a second ion implantation region. The second ion implantation region 6 is a region in which ions which are to be donors, acceptors, or deep levels in the compound semiconductor are implanted. Thereafter, by way of annealing process, a region of the compound semiconductor where ions are implanted into becomes the region of n type, p type, or insulating type in accordance with the kind of implanted ions and the aperture pattern is produced self-aligned at a position apart from the active region or the insulating region by the distance of thermohardening region by the thermal diffusion 3b. In this case, the SiN film 2 is not necessarily required.

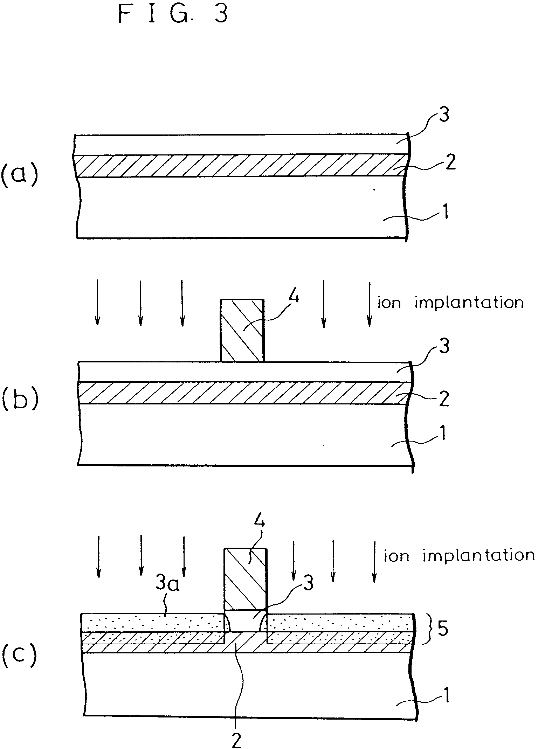

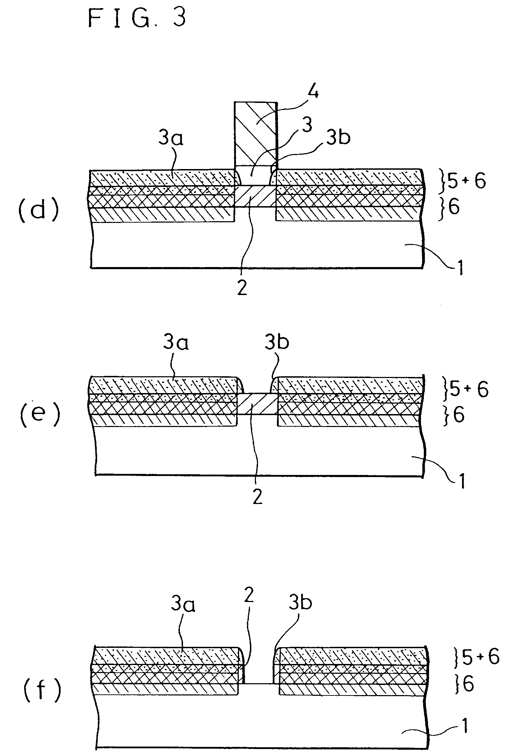

Finally, a third embodiment of the present invention will be described utilizing the first embodiment with reference to figure 3.

Figure 3(a) is the same as figure 1(a). In figure 3(b), photoresist 4 is produced and at first ions are implanted at an energy of which ions do not reach the compound semiconductor to harden the thermohardening resin, thereby producing a first ion implantation region 5 as shown in figure 3(c).

Thereafter, ions which are to be donors, acceptors, or deep levels are implanted at an energy of which ions reach the compound semiconductor substrate as similarly with the second embodiment in figure 3(c), thereby producing a second ion implantation region 6. This is shown in figure 3(d). By this, hardening of the thermohardening resin 3 and ion implantation into the compound semiconductor 1 can be carried out independently and the optimization of conditions is eased. As an example, the hardening of the resin is carried out by implanting silicon ion, argon ion at 100 KeV and about $1 \times 10^{15}$cm$^{-2}$, or krypton ion at 200 KeV and about $1 \times 10^{15}$cm$^{-2}$, thereby hardening the thermohardening resin 3 and thereafter beryllium ion is implanted at 100 KeV or less and about $1 \times 10^{12}$cm$^{-2}$ so as to obtain a required concentration of p type active layer. Silicon ion is implanted at 100 KeV or less about $1 \times 10^{13}$cm$^{-2}$ so as to obtain a required concentration of n type active layer.

These implantation energies are selected from figure 7.

The processes to be carried out thereafter, that is, processes of figures 3(e) and (f) are the same as those of figures 1(e) and (f) and figures 2(d) and (e) shown with reference to the second embodiment.

In the above illustrated embodiment, a method of producing a fine aperture pattern is described. A triple-layer photoresist can be produced by other method.

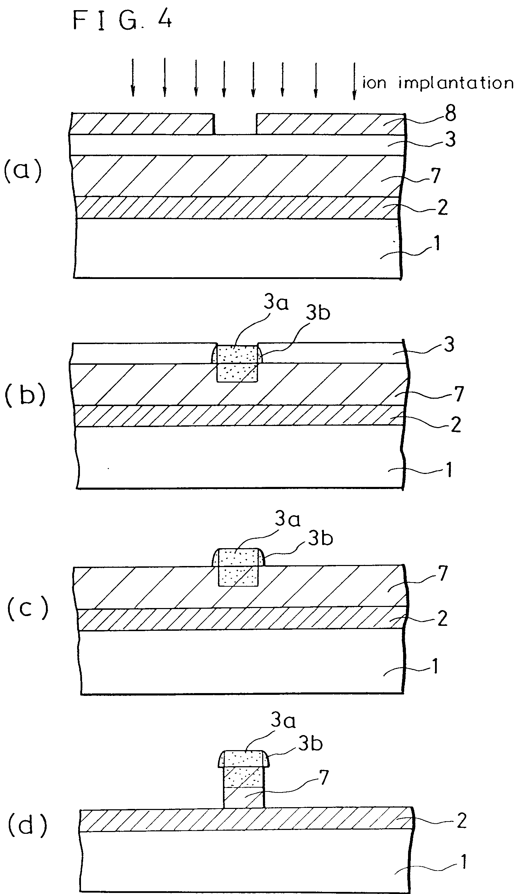

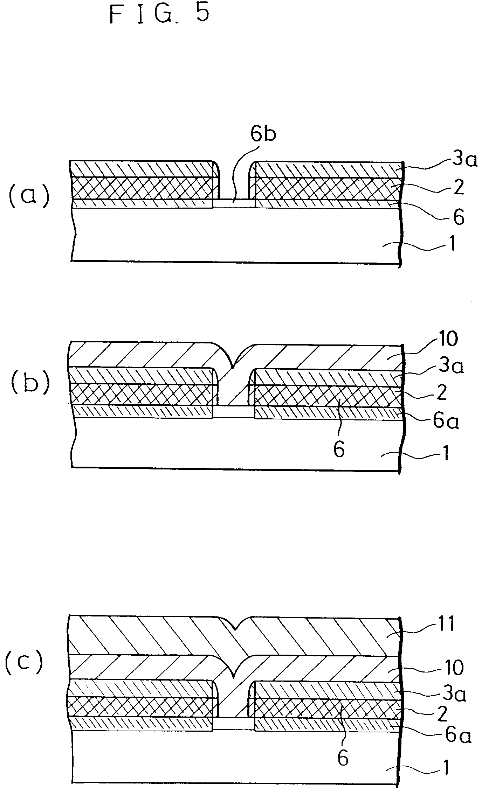

Figure 4 shows a fourth embodiment of the present invention for producing a triple-layer photoresist which has photoresist 8 having a fine through pattern as an upper layer and photoresist 7 as a lower layer of the thermohardening resin 3.

A detailed description thereof will be given hereinbelow.

First of all, as shown in figure 4(a), ions are implanted into the thermohardening resin 3 using the upper layer photoresist 8 as a mask and the thermohardening resin 3 is hardened.

Next, the upper layer photoresist 8 is removed as shown in figure 4(b). When non-hardened resin 3 is also removed by hydrofluoric acid, thermohardening resins 3a and 3b remain as shown in figure 4(c).

Next, the lower layer photoresist 7 is etched by RIE using $O_2$ gas using the thermohardening resins 3a and 3b as a mask as shown in figure 4(d), thereby completing the triple-layer photoresist.

In the prior art production method utilizing a triple-layer photoresist, there is a disadvantage in that a pattern becomes too small as discussed in the background of the invention. However, in this fourth embodiment, RIE is carried out only one time by $O_2$ RIE to produce a triple-layer photoresist and therefore there is less probability that the pattern becomes small.

Therefore, the process utilizing thermal stability and anti-RIE property of the lower layer photoresist 7 and a process utilizing an advantage in that the lower layer photoresist is thick and also has high resolution can be carried out at high controllability and such a production of a fine pattern gate and processing of a wiring pattern can be carried out at high precision.

The above illustrated embodiment can be applied to the productions of compound semiconductor devices as follows:

(1) MESFET,

(2) self-aligned type refractory gate MESFET having a low resistance metal on a gate, and

(3) compound semiconductor device of HEMT.

First of all, an embodiment of a production method of a self-aligned type refractory gate MESFET having a low resistance metal on a gate of the above described paragraph (2) will be described. The production method of MESFET of the above described paragraph (1) can be obtained by only changing a part thereof.

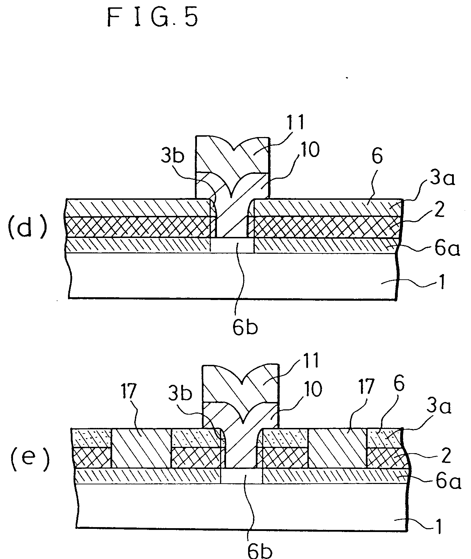

Figure 5(a) corresponds to figure 2(e) and figure 3(f). The n type active layer region 6 is previously produced before the process of figure 2(a) and figure 3(a).

When refractory metal silicide or refractory metal 10 such as WSi, W, Mo is plated by sputtering or evaporation in this state, the state shown in figure 5(b) results. Annealing is carried out in this state, thereby activating the ion implantation region 6 to produce $n^+$ active region 6a in the semiconductor substrate 1.

Next, a low resistance metal 11 such as Au is plated by sputtering or evaporation, thereby resulting in the state of figure 5(c). Next, as shown in figure 5(d), a gate pattern of photoresist is produced on the low resistance metal 11 and the unrequired portions of low resistance metal 11 and refractory metal 10 are removed by ion milling using the photoresist as a mask, and further the photoresist is removed, thereby producing a low resistance gate comprising low resistance metal 11 and refractory metal 10.

Thereafter, contact holes are apertured in the thermohardening resin 3 and the SiN film 2 and an ohmic metal is plated at the contact holes, thereby producing a source and drain electrode as shown in figure 5(e). Or after the thermohardening resin 3 and Sin film 2 are removed, an ohmic metal is plated thereby to produce a source and a drain electrode.

Here, when only MESFET of the above-described paragraph (1) is produced, the gate is patterned in the state of figure 5(b), unrequired parts of refractory metal 10 are removed by RIE, hardened thermohardening resins 3a and 3b and the SiN film 2 are removed, and thereafter an annealing is carried out. Here, in both cases, the SiN film 2 is not required to be provided if the second embodiment is used.

In the MESFET produced in this way, it is possible to produce a fine pattern gate comprising refractory metal at a place apart from the active region by the distance of the thermohardening region by thermal diffusion 3b self-alignedly at high controllability and at high reproducibility.

In a device in which a low resistance metal is provided on refractory metal gate, the gate resistance can be reduced.

An embodiment of a method of producing a HEMT of the above described paragraph (3) will be described.

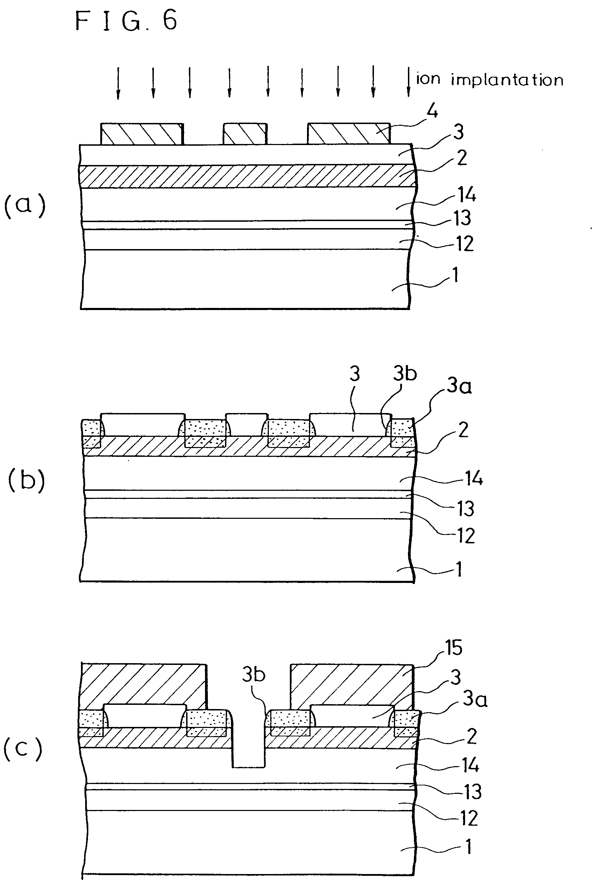

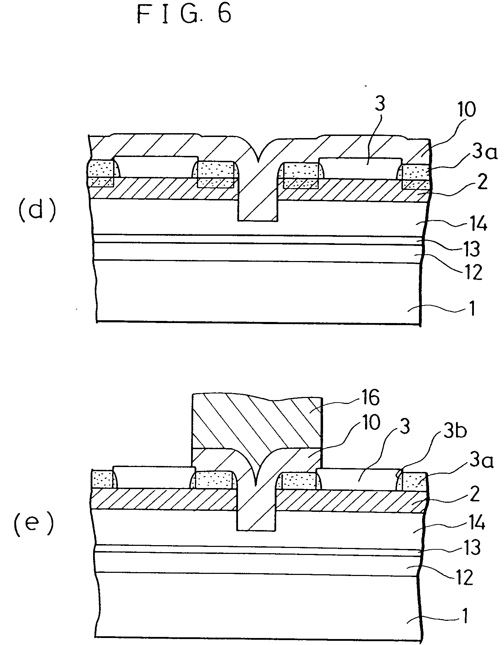

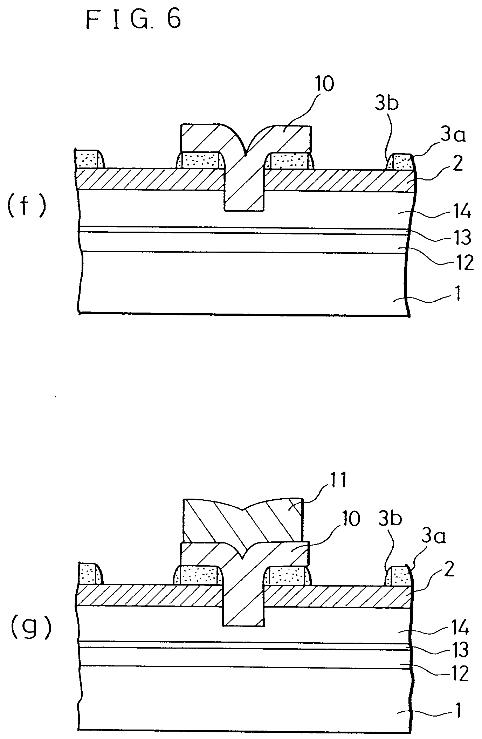

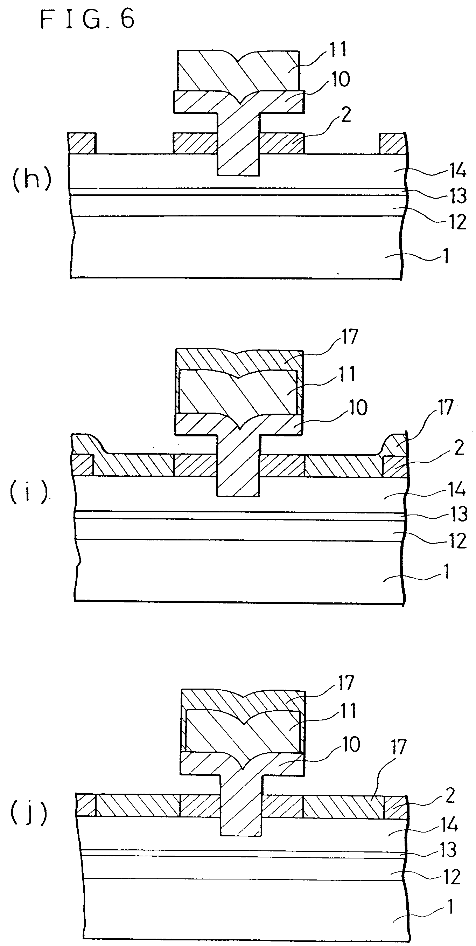

Figure 6(a) shows a state in which a SiN film 2 is plated on an $n^+$-GaAs layer 14 / n-AlGaAs layer 13 / i-GaAs layer 12 produced by epitaxial growth method for HEMT on a compound semiconductor substrate 1, thermohardening resin 3 is plated thereon, and a gate pattern and a source and drain pattern comprising photoresist 4 are produced thereon at the same time, and ions are implanted.

By this, the non-hardened thermohardening resin 3 remains on the gate and the source and drain. When the photoresist 4 is removed, a state shown in figure 6(b) is obtained.

Next, as shown in figure 6(c), patterning is carried out using photoresist 15 and the thermohardening resin 3 at the gate part is removed by hydrofluoric acid and the SiN film 2 is removed by plasma etching, respectively, and further the $n^+$-GaAs layer 14 is recess etched by dry or wet etching.

Next, the refractory metal 10 is sputtered as shown in figure 6(d).

Next, the photoresist 16 is patterned and the refractory metal 10 is etched by RIE as shown in figure 6(e).

Next, the thermohardening resin 3 on the source and drain is removed by hydrofluoric acid as shown in figure 6(g). Annealing is carried out in this state and the damages caused by sputtering of the refractory metal 10 are removed. Next, as shown in figure 6(g), low resistance metal 11 is sputtered or deposited on the refractory metal gate and it is again patterned.

Next, the SiN film 2 is etched using the thermohardening resin 3a and 3b as a mask and the thermohardening resin 3a and 3b which is sufficiently hardened are removed by hydrofluoric acid against the SiN film 2 as shown in figure 6(h). The etching rate of the thermohardening resin 3a and 3b is about ten times as that of the SiN film 2.

Next, an ohmic metal is evaporated as shown in figure 6(i) and patterning is carried out to remove the ohmic metal of the portion other than the gate, source, and drain as shown in figure 6(j), and thereafter sintering is carried out, thereby completing a HEMT.

In the above illustrated embodiment, the SiN film 2 is not required if the second embodiment is employed in the ion implantation process.

Furthermore, in a case where the refractory metal 10 is not sputtered but evaporated, if a low resistance metal 11 is plated in the state of figure 6(d) and thereafter the process of figure 6(e) is carried out to obtain a state of figure 6(g), one patterning process can be omitted.

In the HEMT device of the present invention, the distance between gate and source and the distance between gate and drain can be determined by the first patterning shown in figure 6(a) and a fine pattern gate can be produced.

As is evident from the foregoing description, according to the present invention, photoresist is patterned on thermohardening resin, and a particle beam is implanted using the photoresist as a mask to harden the thermohardening resin, the photoresist is removed, and thereafter an inverted pattern is produced by selectively removing the non-hardened resin part where the particle beam is not implanted, and the inverted pattern is transferred onto the metal, insulating film, or photoresist. Therefore, the broadening of pattern at the production of an aperture and the reduction of pattern at the production of a triple-layer photoresist can be prevented.

Since particle beam of ions of the kind which are to be donors, acceptors, or deep levels in the semiconductor are implanted at an implantation energy of which ions reach the semiconductor substrate, an ion implantation region can be produced in the substrate simultaneously with the inverted pattern, that is, the production process is simplified, and the active region or insulating region can be produced self-aligned with the inverted pattern by annealing which is performed thereafter.

In a production method in which the particle beam is implanted at an energy of which ions cannot reach the substrate and thereafter ions which are to be the donors, acceptors, or deep levels in the semiconductor are implanted at an implantation energy of which ions can reach the semiconductor substrate, and the aperture pattern is produced self-aligned with the implantation region by transferring the above described pattern, the fine pattern gate electrode can be produced self-aligned with the active region and further the kind and the amount of the implantation into the active layer can be arbitrarily determined. In addition, in another production method in which an active region and insulating region are produced in the substrate simultaneously with production of the inverted pattern and the pattern is transferred to produce an aperture pattern, the aperture pattern can be produced self-aligned with these regions, and a MESFET of high reliability can be easily produced by providing a Schottky metal at this aperture and providing an ohmic metal on the ion implantation region.

Furthermore, when a gate electrode is produced at an aperture pattern produced by the transferring of the inverted pattern and a source and drain electrodes are provided at the other aperture patterns, a HEMT having a fine pattern gate produced self-aligned with the source and drain electrode can be obtained and the distance between the gate and source and the distance between gate and drain can be determined by only conducting patterning at the time of producing the inverted pattern by the particle beam implantation.

## Claims

1. A production method of a semiconductor device including a process of producing a mask pattern to be used in the later process on a ground substrate, which process of producing said mask pattern comprising the steps of:

   plating thermohardening resin on said ground substrate;

   implanting particle beam selectively to said thermohardening resin to sufficiently harden said thermohardening resin selectively; and

   removing non-hardened part of said thermohardening resin where said particle beam is not implanted, thereby resulting in said mask pattern comprising a pattern of said remaining thermohardening resin.

2. A production process of a semiconductor device as defined in claim 1, wherein said particle beam implantation process includes a process of implanting kind of ions which are to be donors, acceptors, or deep levels in said semiconductor of said ground substrate including semiconductor at an implantation energy of which ions reach said semiconductor.

3. A production process of a semiconductor device comprising the steps of:

   plating thermohardening resin on a semiconductor substrate or on a semiconductor substrate having an insulating film at a surface thereof;

   producing a photoresist pattern on said thermohardening resin;

   carrying out implantation of ions which are to be donors, acceptors, or deep levels in said semiconductor using said photoresist pattern as a mask at an energy of which ions reach said semiconductor substrate to harden sufficiently said thermohardening resin at said implantation region and producing an ion implantation region in said substrate;

   removing said photoresist pattern and non-hardened portion of said thermohardening resin; and

   transferring a pattern of said remaining thermohardening resin onto the lower layer semiconductor substrate or onto the insulating film on said substrate and producing an aperture part self-aligned with said implantation region.

4. A production method of a semiconductor device comprising the steps of:

   plating thermohardening resin on a semiconductor substrate or on a substrate having an insulating film at a surface thereof;

   producing a photoresist pattern on said thermohardening resin;

   implanting particle beam using said photoresist pattern as a mask to harden sufficiently said thermohardening resin at said particle beam implantation region;

   implanting ions which are to be donors, acceptors, or deep levels in said semiconductor using said photoresist pattern as a mask at an energy of which ions reach said semiconductor substrate to produce an ion implantation region in said substrate;

   removing said photoresist pattern and said non-hardened thermohardening resin; and

   transferring a pattern of said remaining thermohardening resin onto the lower layer semiconductor substrate or onto the insulating film on a substrate and producing an aperture self-aligned with said ion implantation region.

5. A production method of a semiconductor device as defined in claim 3 wherein an active region is previously produced in said semiconductor substrate, ion implantation regions in said substrate are a source and a drain region to which ions which are to be donors, or acceptors in said semiconductor are implanted, and which further comprises a process of producing a Schottky metal at an aperture part which is produced self-aligned with said ion implantation region by said pattern transferring, a process of removing said thermohardening resin on said source and drain region, and a process of producing an ohmic metal on said removed part, thereby producing a MESFET.

6. A production method of a semiconductor device as defined in claim 4 wherein an active region is previously produced in said semiconductor substrate, ion implantation regions in said substrate are a source and a drain region to which ions which are to be donors, or acceptors in said semiconductor are implanted, and which further comprises a process of producing a Schottky metal at an aperture part which is produced self-aligned with said ion implantation region by said pattern transferring, a process of removing said thermohardening resin on said source and drain region, and a process of producing an ohmic metal on said removed part, thereby producing a MESFET.

7. A production method of a semiconductor device for producing a HEMT, comprising the steps of:

plating thermohardening resin on a compound semiconductor substrate on which an active region is produced or via an insulating film on said compound semiconductor substrate;

covering regions corresponding to a gate electrode, a drain electrode, and a source electrode production region on said thermohardening resin by photoresist;

implanting particle beam to said thermohardening resin using said photoresist pattern as a mask to harden sufficiently the thermohardening resin of said particle beam implantation region;

removing said photoresist pattern and removing said non-hardened thermohardening resin at said gate electrode production region;

etching said compound semiconductor substrate or insulating film on said substrate exposed thereby and producing recess groove reaching said active layer;

plating a Schottky metal on said recess groove part;

removing said non-hardened thermohardening resin at said source and drain electrode production region to expose said compound semiconductor substrate; and

plating an ohmic electrode on the surface of exposed substrate.

FIG. 1

(a)

3

2

1

↓ ↓ ↓        ↓   ↓ ion implantation

4

(b)

3

2

1

3a     3    3b

2

1

} 5

(c)

FIG. 1

(d)

3a    3b    }5    2    1

(e)

3a    3b    }5    1    2

F I G. 2

(a)

3
2
1

ion implantation

4

(b)

3
2
1

(c)

3a    3    3b

6

2    1

F I G. 2

(d)

3a   3b

}6

1

2

(e)

3a   3b

}6

1

2

F I G. 3

(a)

(b)

ion implantation

(c)

ion implantation

F I G. 3

(d)

(e)

(f)

# F I G. 4

(a)

ion implantation

(b)

(c)

(d)

F I G. 5

(a)

(b)

(c)

FIG.5

(d)

(e)

# F I G. 6

(a)

ion implantation

(b)

(c)

F I G. 6

(d)

(e)

# F I G. 6

(f)

(g)

FIG. 6

(h)

(i)

(j)

# F I G. 7

FIG. 8 (PRIOR ART)

(a)

4

2a

1

(b)

4

2a

1

(c)

2a

1

F I G. 9 (PRIOR ART)

(a)

(b)

(c)